Europäisches Patentamt

European Patent Office

Office européen des brevets

(11) Veröffentlichungsnummer: **0 304 796 B1**

(19)

(12) **EUROPÄISCHE PATENTSCHRIFT**

(45) Veröffentlichungstag der Patentschrift: **23.03.94**

(21) Anmeldenummer: **88113396.1**

(22) Anmeldetag: **18.08.88**

(51) Int. Cl.⁵: **H01S 3/19**, H01S 3/08

(54) **Halbleiterlaser mit konstanter differentieller Ouantenausbeute oder konstanter optischer Ausgangsleistung.**

(30) Priorität: **25.08.87 DE 3728305**

(43) Veröffentlichungstag der Anmeldung:
**01.03.89 Patentblatt 89/09**

(45) Bekanntmachung des Hinweises auf die
Patenterteilung:
**23.03.94 Patentblatt 94/12**

(84) Benannte Vertragsstaaten:
**DE FR GB IT NL**

(56) Entgegenhaltungen:
**DE-A- 2 410 559      US-A- 3 943 462**
**US-A- 4 092 659      US-A- 4 280 107**
**US-A- 4 510 607      US-A- 4 599 729**

(73) Patentinhaber: **Alcatel SEL Aktiengesellschaft**
**Lorenzstrasse 10**
**D-70435 Stuttgart(DE)**

(84) Benannte Vertragsstaaten:
**DE**

(73) Patentinhaber: **ALCATEL N.V.**
**Strawinskylaan 537,**
**(World Trade Center)**
**NL-1077 XX Amsterdam(NL)**

(84) Benannte Vertragsstaaten:

**FR GB IT NL**

(72) Erfinder: **Mozer, Albrecht, Dr.**
**Freiberger Strasse 30**
**D-7120 Bietigheim(DE)**
Erfinder: **Lösch, Kurt, Dr.**
**Birkenwaldstrasse 165 A**
**D-7000 Stuttgart 1(DE)**

(74) Vertreter: **Pohl, Herbert, Dipl.-Ing et al**
**Alcatel SEL AG**
**Patent- und Lizenzwesen**
**Postfach 30 09 29**
**D-70449 Stuttgart (DE)**

Anmerkung: Innerhalb von neun Monaten nach der Bekanntmachung des Hinweises auf die Erteilung des europäischen Patents kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

EP 0 304 796 B1

**Beschreibung**

Die Erfindung betrifft einen Halbleiterlaser, im folgenden kurz HL-Laser genannt, mit konstanter differentieller Quantenausbeute oder konstanter optischer Ausgangsleistung.

Differentielle Quantenausbeute $\eta_{ext}$ und optische Ausgangsleistung $P_{opt}$ einer Laserdiode sind stark temperaturabhängig. Für viele Anwendungen sind jedoch entweder eine nahezu temperaturunabhängige differentielle Quantenausbeute $\eta_{ext}$ oder eine nahezu temperaturunabhängige Ausgangsleistung $P_{opt}$ erwünscht. Für die optische Nachrichtenübertragung mit Intensitätsmodulation ist eine temperaturunabhängige differentielle Quantenausbeute deshalb nützlich, weil nur so ein konstanter Modulationshub des Steuerstromes in eine konstante Modulationstiefe des optischen Signales umgesetzt wird. Bei Verwendung einer Laserdiode als Sender, bei dem eine konstante Gleichlichtleistung erforderlich ist, sollte die optische Ausgangsleistung (bei konstantem Injektionsstrom) temperaturunabhängig sein.

Aus der DE-OS 35 34 744 ist eine Laservorrichtung mit stabilisierter optischer Ausgangsleistung bekannt, bei der der durch die Laserdiode fließende Strom durch einen temperaturabhängigen Kompensationswiderstand so beeinflußt wird, daß die von der Laserdiode abgestrahlte optische Leistung weitgehend temperaturunabhängig ist. Dabei ist sicherzustellen, daß der temperaturabhängige Widerstand und die Laserdiode dieselbe Temperatur aufweisen.

Die bekannte Einrichtung hat den Nachteil, daß schon kleinere Temperaturabweichungen zwischen Laserdiode und Kompensationswiderstand zu großen Schwankungen der optischen Ausgangsleistung führen, was für viele Anwendungen unerwünscht ist.

Aufgabe der vorliegenden Erfindung ist es daher, die Temperatureinflüsse auf die optische Ausgangsleistung oder aber auf die differentielle Quantenausbeute möglichst weitgehend auszuschalten. Gelöst wird diese Aufgabe durch eine Vorrichtung mit den Merkmalen des Patentanspruchs 1.

Der wichtigste Vorteil dieser Vorrichtung ist darin zu sehen, daß zur Konstanthaltung der differentiellen Quantenausbeute oder der optischen Ausgangsleistung hier nicht in die Stromzufuhr der Laserdiode eingegriffen werden muß. Der unerwünschte Temperatureinfluß wird hier vielmehr mit rein optischen Mitteln ausgeschaltet.

Weitere Vorteile der Erfindung ergeben sich aufgrund der in den Unteransprüchen aufgeführten Merkmale.

Anhand der Figuren 1 bis 5 wird nachfolgend ein Ausführungsbeispiel der Erfindung eingehend beschrieben.

Es zeigen:

Fig. 1  die <u>tatsächliche</u> und die zur Erzeugung einer konstanten differentiellen Quantenausbeute <u>gewünschte</u> Abhängigkeit der optischen Strahlungsleistung $P_{opt}$ vom Steuerstrom I für verschiedene Temperaturen,

Fig. 2  schematisch einen Halbleiterlaser mit den dielektrischen Schichten und/oder Verspiegelungsschichten gemäß der Erfindung,

Fig. 3  den Verlauf des Produktes $R_1 R_2$ über der Wellenlänge für eine temperaturunabhängige Quantenausbeute,

Fig. 4  die tatsächliche und die zur Erzeugung einer konstanten optischen Ausgangsleistung gewünschte Abhängigkeit $P_{opt}$ vom Steuerstrom für unterschiedliche Temperaturen und

Fig. 5  den Verlauf des Produktes $R_1 R_2$ über der Wellenlänge für eine temperaturunabhängige optische Ausgangsleistung.

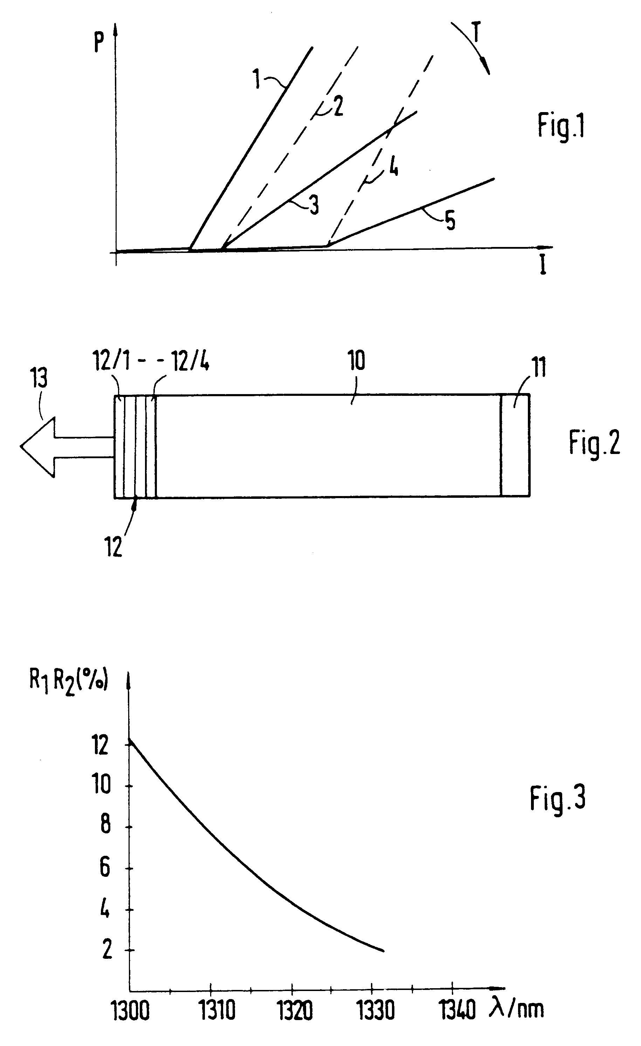

In Fig. 1 mit 1, 3 und 5 bezeichnete Kennlinien geben die Abhängigkeit der optischen Ausgangsleistung P einer HL-Laserdiode vom Steuerstrom I für verschiedene Temperaturen T wieder. Dabei nimmt die Temperatur von der Kennlinie 1 zur Kennlinie 5 hin zu. Mit wachsender Temperatur nimmt die Steigung der Kennlinien, die ein Maß für die differentielle Quantenausbeute ist, ab. Eine temperaturunabhängige differentielle Quantenausbeute hätte man dann, wenn die Kennlinien den Verlauf der gestrichelt gezeichneten Linien 2 und 4 hätten, welche parallel zur Kennlinie 1 verlaufen. Im folgenden wird beschrieben, wie sich mit Hilfe optischer Maßnahmen ein Kennlinienverlauf entsprechend der mit 2 und 4 bezeichneten Kennlinien erreichen läßt.

In Fig. 2 ist schematisch ein Halbleiterlaser dargestellt, 10 bezeichnet eine Laserdiode, mit 11 ist eine Verspiegelungsschicht auf der Rückseite der Diode, mit 12 eine dielektrische Schicht auf der Vorderseite der Diode bezeichnet. Die von der Laserdiode erzeugte optische Leistung wird auf der Vorderseite der Laserdiode aus dieser ausgekoppelt, was durch den Pfeil 13 angedeutet ist. Die dielektrische Schicht 12 besteht aus Teilschichten 12/1 bis 12/4. Jede dieser Teilschichten weist einen anderen Brechungsindex auf. Die Brechungsindices der einzelnen Teilschichten sind so gewählt, daß sich ein gewünschter, vorherbestimmbarer wellenlängenabhängiger Reflexionskoeffizient ergibt. Der Reflexionskoeffizient der Schicht 12

wird mit $R_1$, der Reflexionskoeffizient der Schicht 11 mit $R_2$ bezeichnet. Prinzipiell ist es auch möglich, daß anstelle der Schicht 12 die Schicht 11 aus mehreren Teilschichten besteht, oder daß beide Schichten 11 und 12 aus Teilschichten aufgebaut sind.

Die von einer Laserdiode abgestrahlte Wellenlänge hängt von der Temperatur der Laserdiode ab. Für das hier dargestellte Ausführungsbeispiel, eine InGaAsP/InP-Laserdiode, gilt

$$\lambda(T) = \lambda(0°C) + 0{,}45 \tfrac{nm}{°C} T(°C) \qquad (1)$$

Durch Verschiebung der Emissionswellenlänge durch einen geeignet gewählten Verlauf des Reflexionskoeffizienten als Funktion der Wellenlänge kann nun erreicht werden, daß der Reflexionskoeffizient des Laserspiegels 12 bei höheren Temperaturen kleiner ist als bei niedrigeren Temperaturen, mit anderen Worten, daß der Reflexionskoeffizient der Schicht 12 mit wachsender Wellenlänge abnimmt, so daß mit wachsender Wellenlänge ein immer größerer Teil der vom Laser erzeugten Lichtleistung aus dem Laser ausgekoppelt wird. Durch diese Maßnahme erreicht man eine temperaturunabhängige differentielle Quantenausbeute, wie sie in den Kennlinien 2 und 4 der Fig. 1 gestrichelt dargestellt ist.

Der erforderliche Verlauf des Reflexionskoeffizienten wird wie folgt berechnet:

$$\eta_{ext} = \eta_{int} \frac{\ln \frac{1}{R_1 R_2}}{2L \, \alpha_{int} + \ln \frac{1}{R_1 R_2}} \qquad (2)$$

Die externe differentielle Quantenausbeute $\eta_{ext}$ soll konstant sein. Außerdem wurde angenommen, daß die interne Quantenausbeute $\eta_{int}$ temperaturunabhängig ist. Dies stellt keine Einschränkung der Allgemeinheit der Erfindung dar.

$$\frac{1}{\dfrac{2L \, \alpha_{int}}{\ln \frac{1}{R_1 R_2}} + 1} = \text{konstant}$$

Daraus folgt:

$$\frac{2L \, \alpha_{int}}{\ln \frac{1}{R_1 R_2}} = \text{konstant}$$

Darin sind:

$\eta_{ext}$ = externe Quantenausbeute
$\eta_{int}$ = interne Quantenausbeute
L = Länge des Resonators
$\alpha_{int}$ = interner Absorptionskoeffizient.

Der Absorptionskoeffizient $\alpha_{int}$ und dessen Temperaturabhängigkeit muß vor der Entspiegelung experimentell ermittelt werden. Ändert sich der Absorptionskoeffizient durch Entspiegeln bzw. Verspiegeln, so ist dies durch Testreihen zu ermitteln und muß mit berücksichtigt werden.

Beim nicht entspiegelten Laser - d.h. einem Laser ohne die dielektrischen Schichten 11 und 12 - ergibt sich bei einer Temperatur von 0°C ein Wert von ca. $(0{,}35)^2$ für das aus den beiden Reflexionskoeffizienten

$R_1$ und $R_2$ gebildete Produkt, falls es sich um einen InGaAsP/InP-Laser handelt. Mit diesem Wert erhält man dann:

$$(R_1 R_2)_T = \exp\left(-2,1 \frac{\alpha_{int}(T)}{\alpha_{int}(T=0 \ C)}\right) \qquad (3)$$

Tabelle I zeigt die experimentell ermittelten Werte des Absorptionskoeffizienten, die Produkte $R_1 \cdot R_2$ und die Emissionswellenlänge für verschiedene Temperaturen. Die Produkte $R_1 \cdot R_2$ wurden entsprechend Gleichung (3) berechnet.

Tabelle I

| T(°C) | $\alpha$int(T)(1/cm) (***) | $R_1 R_2$(T)(%) (**) | $\lambda$(T) /(nm) (*) |
|---|---|---|---|
| 0 | 51,7 | 12,2 | 1300 |
| 10 | 56,4 | 10,1 | 1304,5 |
| 20 | 61,5 | 8,2 | 1309,0 |
| 30 | 67,3 | 6,5 | 1313,5 |
| 40 | 74,0 | 4,95 | 1318 |
| 50 | 81,0 | 3,8 | 1322,5 |
| 60 | 88,0 | 2,8 | 1327 |
| 70 | 96,0 | 2 | 1331,5 |

(*) aus Gleichung (1)
(**) aus Gleichung (3)
(***) vor dem Entspiegeln experimentell ermittelt

In Fig. 3 ist der Verlauf des Produktes $R_1 \cdot R_2$ über der Wellenlänge $\lambda$ wiedergegeben, der zu einer temperaturunabhängigen differentiellen Quantenausbeute, bezogen auf beide Laserspiegel von 50,4% für einen 200 μm langen Laser, führt. Diese spektrale Abhängigkeit des Reflexionskoeffizientenprodukts $R_1 \cdot R_2$ kann durch mehrlagige dielektrische Entspiegelungsschichten realisiert werden.

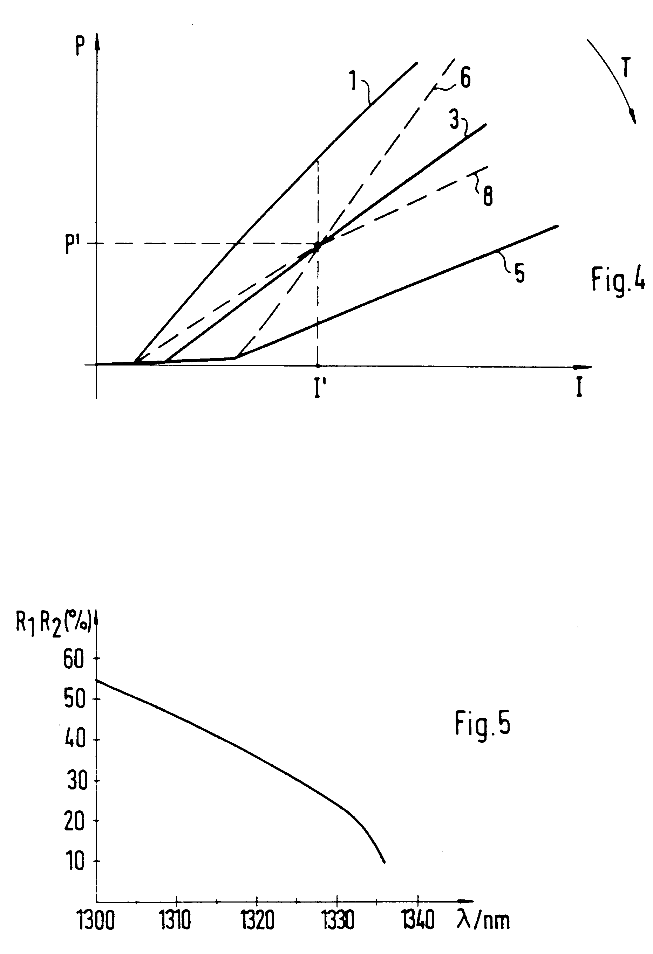

Der geschichtete Aufbau der Schicht 12 läßt sich auch dazu verwenden, eine Laserdiode mit temperaturunabhängiger optischer Ausgangsleistung herzustellen. In Fig. 4 sind mit 1, 3 und 5 wiederum die Kennlinien optischer Ausgangsleistung abhängig vom Steuerstrom für verschiedene Temperaturen bezeichnet.

Mit 3, 6 und 8 sind Kennlinien bezeichnet, die für verschiedene Temperaturen bei festem Steuerstrom I' zu einer konstanten optischen Ausgangsleistung P' führen.

In Tabelle II sind die Werte für das Produkt $R_1 R_2$ zusammengestellt, die zu einer temperaturunabhängigen optischen Ausgangsleistung führen. Vorausgesetzt wurde dabei eine Ausgangsleistung P' = 10 mW und ein Injektionsstrom I' von 32 mA sowie eine Laserlänge L von 100 μm.$I_{th}$ ist dabei der Strom, welcher mindestens erforderlich ist, damit die Laserstruktur Laseroszillationen zeigt.

4

Tabelle II

| T($^\circ$C) | $I_{th}$(mA) | $\eta_{ext}$ beide Laserspiegel (%) | $R_1 R_2$(%) (**) | (nm) (T) (*) |
|---|---|---|---|---|
| 0 | 5,2 | 37,2 | 54,2 | 1300 |
| 10 | 5,4 | 37,6 | 50,6 | 1304,5 |
| 20 | 5,75 | 38,1 | 46,9 | 1309 |
| 30 | 6,23 | 38,8 | 42,6 | 1313,5 |
| 40 | 6,8 | 39,7 | 37,8 | 1318 |
| 50 | 7,6 | 41 | 32,5 | 1322,5 |
| 60 | 8,58 | 42,7 | 26,9 | 1327 |
| 70 | 9,98 | 45,42 | 20,2 | 1331,5 |
| 80 | 12,8 | 52 | 9,56 | 1336 |

P' = 10 mW I' = 32 mA

L = 100 $\mu$m

(*) aus Gleichung (1)

(**) aus Gleichung (2), wobei für $\alpha_{int}$ die Werte von Tabelle I angesetzt werden.

In Figur 5 ist der Verlauf von $R_1 R_2$ über der Wellenlänge graphisch dargestellt. Dieser geforderte spektrale Verlauf läßt sich z.B. durch mehrlagige Teilverspiegelung der Laserspiegel realisieren.

Der Grundgedanke der Erfindung, nämlich durch geeignete Entspiegelungen bzw. Verspiegelung des Lasers die differentielle Quantenausbeute oder die Ausgangsleistung konstant zu halten, bleibt nicht auf den Anwendungsfall und das Ausführungsbeispiel Laserdiode beschränkt. Es läßt sich auf jeden Festkörperlaser und auch auf andere Lasertypen übertragen, sofern der Zusammenhang zwischen emittierter Wellenlänge und Temperatur, sowie die Temperaturabhängigkeit des internen Absorptionskoeffizienten experimentell ermittelt wurden bzw. bekannt sind.

**Patentansprüche**

1. Halbleiterlaser mit mindestens je einer dielektrischen, reflektierenden Schicht (11, 12) auf jeder seiner Endflächen, **dadurch gekennzeichnet,** daß zumindest eine auf der als Lichtaustrittsfläche benutzten Endfläche befindliche Schicht (12) aus einem Material besteht, welches bewirkt, daß das Reflexionsvermögen der Schicht (12) mit zunehmender Lichtwellenlänge abnimmt, so daß sich eine temperaturunabhängige differentielle Quantenausbeute oder eine termperaturunabhängige optische Ausgangsleistung ergibt.

2. Halbleiterlaser nach Anspruch 1, dadurch gekennzeichnet, daß eine Auswahl des Schichtmaterials hinsichtlich der Abhängigkeit des Reflexionsvermögens der Schicht von der Lichtwellenlänge derart getroffen ist, daß ein aufgrund der Temperaturabhängigkeit der Lichtwellenlänge und des mit Zunahme der Lichtwellenlänge abnehmenden Reflexionsvermögens der Schicht auftretender Zuwachs der Lichtausgangsleistung (P') des Lasers eine charakteristische Abnahme der differentiellen Quantenausbeute des Lasermaterials mit der Temperatur in ihrer Wirkung auf die Lichtausgangsleistung kompensiert.

3. Halbleiterlaser nach Anspruch 1, dadurch gekennzeichnet, daß eine Auswahl des Schichtmaterials hinsichtlich der Abhängigkeit des Reflexionsvermögens der Schicht von der Lichtwellenlänge derart getroffen ist, daß ein aufgrund der Temperaturabhängigkeit der Lichtwellenlänge und des mit Zunahme der Lichtwellenlänge abnehmenden Reflexionsvermögens der Schicht auftretender Zuwachs der Lichtausgangsleistung (P') des Lasers eine aufgrund einer Temperaturerhöhung erfolgende Abnahme der Lichtausgangsleistung bei konstantem Injektionsstrom (I') kompensiert.

4. Halbleiterlaser nach Anspruch 1 oder 2, dadurch gekennzeichnet, daß der Halbleiterlaser aus In-GaAsP/InP besteht und das für die auf den Halbleiterlaser aufgebrachten Schichten verwendete dielektrische Material so ausgewählt ist, daß die Reflexionsvermögen der Schichten der Beziehung

$$R_1 \cdot R_2(T) = \exp\left(-2.1\,\frac{\alpha_{int}(T)}{\alpha_{int}(T=0°C)}\right)$$

genügen, wobei $\alpha_{int}$ (T) ein temperaturabhängiger innerer Absorptionskoeffizient des Halbleiterlasers ist und vor dessen Entspiegelung experimentell aus der differentiellen Quantenausbeute des Lasers bestimmt wurde.

5. Halbleiterlaser nach einem der Ansprüche 1 bis 4, dadurch gekennzeichnet, daß die Lichtaustrittsfläche mit einer Folge übereinanderliegender dielektrischer Schichten (12/1...12/4) mit unterschiedlichen Brechungsindices beschichtet ist.

## Claims

1. A semiconductor laser having at least one dielectric, reflective coating (11, 12) on each of its end faces, **characterized in** that at least one coating (12), located on the end face used as light output face, is made of a material which causes the reflectivity of the coating (12) to decrease with increasing light wavelength, so that a temperature-independent differential quantum efficiency or a temperature-independent optical power output is obtained.

2. A semiconductor laser as claimed in claim 1, characterized in that the coating material is selected with regard to the dependence of the reflectivity of the coating on the light wavelength such that an increase in the light output (P') of the laser as a result of the temperature dependence of the light wavelength and the reflectivity of the coating decreasing with increasing light wavelength compensates a characteristic decrease in the differential quantum efficiency of the laser material with temperature in terms of its effect on the light output.

3. A semiconductor laser as claimed in claim 1, characterized in that the coating material is selected with regard to the dependence of the reflectivity of the coating on the light wavelength such that an increase in the light output (P') of the laser as a result of the temperature dependence of the light wavelength and the reflectivity of the coating decreasing with increasing light wavelength compensates for a decrease in light output due to a temperature increase at a constant injection current (I').

4. A semiconductor laser as claimed in claim 1 or 2, characterized in that the semiconductor laser is made of InGaAsP/InP, and that the dielectric material used for the coatings applied to the semiconductor laser is selected so that the reflectivities of the coatings satisfy the relationship

$$R_1 \cdot R_2(T) = \exp\left(-2.1\,\frac{\alpha_{int}(T)}{\alpha_{int}(T=0°C)}\right)$$

where $\alpha_{int}$ (T) is a temperature-dependent internal absorption coefficient of the semiconductor laser, which was determined experimentally from the differential quantum efficiency of the laser prior to the application of the reflection-reducing coating.

5. A semiconductor laser as claimed in any one of claims 1 to 4, characterized in that the light output face is covered with a sequence of superposed dielectric layers (12/1...12/4) having different indices of refraction.

## Revendications

**1.** Laser à semi-conducteur comportant au moins une couche diélectrique réfléchissante (11, 12) sur chacune de ses surfaces d'extrémité, caractérisé par le fait qu'au moins une couche (12) se trouvant sur la surface d'extrémité utilisée comme surface de sortie de la lumière est constituée d'un matériau qui fait que la réflectance de la couche (12) décroît lorsque la longueur d'onde de la lumière croît, de sorte que l'on obtient un rendement quantique différentiel indépendant de la température ou une puissance optique de sortie indépendante de la température.

**2.** Laser à semi-conducteur selon la revendication 1, caractérisé par le fait que le choix du matériau de la couche, du point de vue de la dépendance de la réflectance de la couche à l'égard de la longueur d'onde de la lumière, se fait de façon telle qu'un accroissement de la puissance lumineuse de sortie (P') des lasers, survenant du fait de la dépendance de la longueur d'onde de la lumière à l'égard de la température et du fait que la réflectance de la couche décroît lorsque la longueur d'onde de la lumière croît, compense une décroissance caractéristique du rendement quantique différentiel du matériau du laser avec la température dans son action sur la puissance lumineuse de sortie.

**3.** Laser à semi-conducteur selon la revendication 1, caractérisé par le fait que le choix du matériau de la couche, du point de vue de la dépendance de la réflectance de la couche à l'égard de la longueur d'onde de la lumière, se fait de façon telle qu'un accroissement de la puissance lumineuse de sortie (P') du laser, survenant du fait de la dépendance de la longueur d'onde de la lumière à l'égard de la température et du fait que la réflectance de la couche décroît lorsque la longueur d'onde de la lumière croît, compense une décroissance de la puissance lumineuse de sortie, à courant d'injection constant (I'), résultant d'une croissance de la température.

**4.** Laser à semi-conducteur selon la revendication 1 ou 2, caractérisé par le fait que le laser à semi-conducteur est constitué de InGaAsP/InP et que l'on choisit le matériau diélectrique employé pour les couches rapportées sur le laser à semi-conducteur de façon telle que les réflectances des couches satisfont la relation:

$$R_1 \cdot R_2(T) = \exp\left(-2{,}1\,\frac{\alpha_{int}(T)}{\alpha_{int}(T=0°C)}\right)$$

$\alpha_{int}(T)$ étant un coefficient d'absorption intérieur, fonction de la température, du laser à semi-conducteur et étant déterminé expérimentalement à partir du rendement quantique différentiel du laser avant l'atténuation de la propriété réfléchissante du laser.

**5.** Laser à semi-conducteur selon l'une des revendications 1 à 4, caractérisé par le fait que la surface de sortie de la lumière est revêtue d'une suite de couches diélectriques superposées (12/1...12/4) d'indice de réfraction différent.

Fig.1

Fig.2

Fig.3

Fig.4

Fig.5